# EUROPEAN PATENT APPLICATION

(11) **EP 4 839 058 A1**
(43) Date of publication of application: **11.11.2026**
(21) Application number: 25793237.6
(22) Date of filing: 27.02.2025
(51) Int. Cl.: H10F 77/20, H10F 19/90

(54) **BUSBAR-LESS BACK CONTACT BATTERY, BATTERY STRING, BATTERY ASSEMBLY, AND PHOTOVOLTAIC SYSTEM**

(30) Priority: 26.04.2024 CN 202410515997
(71) Applicant: Zhejiang Aiko Solar Energy Technology Co., Ltd., Yiwu, Jinhua Zhejiang 322000 (CN); Zhuhai Fushan Aiko Solar Energy Technology Co., Ltd., FushanIndustrial Park, Doumen District Zhuhai Guangdong 519000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, Jianjun, Jinhua, Zhejiang 322000 (CN); CHEN, Gang, Jinhua, Zhejiang 322000 (CN)
(74) Representative: EP&C
(86) International application number: PCT/CN2025/079645
(87) International publication number: WO 2025/223039

(57) **Abstract**

The present disclosure is applicable to the technical field of solar cells, and provides a zero-busbar back-contact cell, a cell string, a cell assembly, and a photovoltaic system. **In** the solar cell, each of first fingers has a first soldered segment at a crossing portion with a first series connection region, all the first soldered segments are located within the first series connection region, and at least one first soldered segment and the remaining first soldered segments are misaligned with each other in a first direction within the first series connection region. According to an arrangement order of the first soldered segments in the first direction, a first line segment formed by sequentially connecting center points of all the first soldered segments is a non-straight segment, and the first line segment has at least one first recessed segment. Therefore, when pre-fixing a ribbon using a first pre-adhesive, the first pre-adhesive can be arranged at a position where an opening of the first recessed segment faces, so that a distance between the first pre-adhesive and the first soldered segment in the first recessed segment corresponding to the first pre-adhesive is relatively far, which can effectively avoid pseudo soldering in the subsequent soldering process.

## Description

The present disclosure claims priority to Chinese Patent Application No. 202410515997.8, filed on April 26, 2024 and entitled "Zero-Busbar Back-Contact Cell, Cell String, Cell Assembly, and Photovoltaic System", the disclosure of which is hereby incorporated by reference in its entirety.

### Technical Field

The present disclosure relates to the technical field of solar cells, and in particular, to a zero-busbar back-contact cell, a cell string, a cell assembly, and a photovoltaic system.

### Background Art

In the related art, in a zero-busbar back-contact solar cell, a solder paste pad is arranged at a position for connection with a ribbon on each of fingers, and at the same time, in order to avoid the ribbon from being offset during lamination and soldering, it is necessary to pre-fix the ribbon by arranging a pre-adhesive near the solder paste pad. In order to ensure accurate bonding, it is usually necessary to arrange the pre-adhesive near the center of the ribbon, which is close to the position of the solder paste pad. In this case, there is a height difference between the pre-adhesive and the solder paste pad. If the height of the pre-adhesive is higher, in a case of ensuring stable bonding of the ribbon, due to the short distance between the pre-adhesive and the solder paste pad, the ribbon cannot be in contact with the solder paste pad when pre-fixing the ribbon, resulting in pseudo soldering in the subsequent soldering process. However, if the height of the solder paste pad is higher, in a case of ensuring the contact between the ribbon and the solder paste pad, due to the short distance between the pre-adhesive and the solder paste pad, the adhesion between the ribbon and the pre-adhesive may decrease or even fail.

Therefore, how to effectively avoid pseudo soldering of the zero-busbar back-contact cell during lamination and soldering while ensuring the stability of pre-fixing the ribbon has become a technical problem studied by technicians.

### Summary

The present disclosure provides a zero-busbar back-contact cell, a cell string, a cell assembly, and a photovoltaic system, so as to solve the technical problem of how to effectively avoid pseudo soldering of the zero-busbar back-contact cell during lamination and soldering while ensuring the stability of pre-fixing the ribbon.

The present disclosure is implemented in this way. A zero-busbar back-contact cell of embodiments of the present disclosure includes:
a silicon substrate and a plurality of first fingers and a plurality of second fingers arranged on a back surface of the silicon substrate, wherein the plurality of first fingers and the plurality of second fingers are sequentially and alternately arranged at intervals in a first direction , each extending in a second direction, and the second direction crosses the first direction; the back surface comprises a plurality of first series connection regions and a plurality of second series connection regions for arranging ribbons, the plurality of first series connection regions and the plurality of second series connection regions extending in the first direction and crossing all the first fingers and all the second fingers , and the plurality of first series connection regions and the plurality of second series connection regions are sequentially and alternately arranged at intervals in the second direction ;
each of the first fingers comprises a first soldered segment at a crossing portion with each of the first series connection regions, and all the first soldered segments are located within the first series connection regions; each of the second fingers comprises a second soldered segment at a crossing portion with each of the second series connection regions, and all the second soldered segments are located within the second series connection regions;
wherein at least one first soldered segment and the remaining at least one first soldered segment are misaligned with each other in the first direction within the first series connection region; and
according to an arrangement order of the first soldered segments in the first direction, a first line segment formed by sequentially connecting center points of all the first soldered segments is a non-straight segment, and the first line segment comprises at least one first recessed segment.

In some embodiments, every two first soldered segments, which are misaligned with each other in the first direction, include an overlapping portion in the first direction.

In some embodiments, a length of the overlapping portion in the second direction is 50 um to 200 um.

In some embodiments, every two first soldered segments, which are misaligned with each other in the first direction, are spaced apart from each other in the second direction.

In some embodiments, a distance between the two first soldered segments, which are misaligned with each other in the first direction, in the second direction is 100 um to 2.5 mm.

In some embodiments, a number of the first soldered segments corresponding to each of the first recessed segment.

In some embodiments, the first line segment further includes at least one first straight segment, the first straight segment being arranged parallel to the first direction, and the first recessed segment is offset in the second direction relative to the first straight segment.

In some embodiments, the first recessed segment includes at least one first sub-straight segment parallel to the first straight segment and at least one first inclined segment connecting the first sub-straight segment and the first straight segment.

In some embodiments, it includes a number of the first straight segments and the first recessed segments is plural, and a plurality of first straight segments and a plurality of first recessed segments are sequentially and alternately arranged.

In some embodiments, in every two first recessed segments at both ends of the first straight segment, one of the first recessed segments is recessed toward one side of the first straight segment and the other of the first recessed segments is recessed toward the other side of the first straight segment.

In some embodiments, the first line segment is a wavy line.

In some embodiments, each of the second fingers comprises a second soldered segment at a crossing portion with each of the second series connection regions, and all the second soldered segments are located within the second series connection regions, and at least one second soldered segment and the remaining at least one second soldered segment are misaligned with each other in the first direction within the second series connection regions;
wherein, according to an arrangement order of the second soldered segments in the first direction, a second line segment formed by sequentially connecting center points of all the second soldered segments is a non-straight segment, and the second line segment comprises at least one second recessed segment.

In some embodiments, every two second soldered segments, which are misaligned with each other in the first direction, include an overlapping portion in the first direction.

In some embodiments, a length of the overlapping portion in the second direction is 50 um to 200 um.

In some embodiments, the two second soldered segments, which are misaligned with each other in the first direction, are spaced apart from each other in the second direction.

In some embodiments, a distance between every two second soldered segments, which are misaligned with each other in the first direction, in the second direction is 100 um to 2.5 mm.

In some embodiments, the second line segment further includes at least one second straight segment, the second straight segment being arranged parallel to the second direction, and the second recessed segment is offset in the second direction relative to the second straight segment.

In some embodiments, the second recessed segment includes at least one second sub-straight segment parallel to the second straight segment and at least one second inclined segment connecting the second first sub-straight segment and the second straight segment.

In some embodiments, the number of the second straight segments and the second recessed segments is plural, and the plurality of second straight segments and the plurality of second recessed segments are sequentially and alternately arranged.

In some embodiments, in every two second recessed segments at both ends of the second straight segment, one of the second recessed segments is recessed toward one side of the second straight segment and the other of the second recessed segments is recessed toward the other side of the second straight segment.

In some embodiments, the second line segment is a wavy line.

The present disclosure further provides a cell string, including:
a plurality of zero-busbar back-contact cells, which can be any one of above;
soldering layers arranged on the first soldered segments and the second soldered segments;
first pre-adhesives arranged within the first series connection region and arranged corresponding to the first recessed segment, and an opening of the first recessed segment facing the first pre-adhesive;
second pre-adhesives arranged within the second series connection region; and
ribbons covering the first series connection regions and the second series connection regions, the ribbon on the first series connection region being bonded to the first pre-adhesive and in contact with the soldering layer on the first soldered segment, and the ribbon on the second series connection region being bonded to the second pre-adhesive and in contact with the soldering layer on the second soldered segment.

In some embodiments, a distance between the first pre-adhesive and the first soldered segment located on the first recessed segment is 100 um to 2 mm; and/or
length of the first pre-adhesive in the second direction is 300 um to 2 mm.

In some embodiments, a number of the first pre-adhesives corresponding to the single first recessed segment .

In some embodiments, at least one second soldered segment and the remaining at least one second soldered segments are misaligned with each other in the first direction within the first series connection region.

According to an arrangement order of the second soldered segments in the first direction, a second line segment formed by sequentially connecting center points of all the second soldered segments is a non-straight segment, the second line segment has at least one second recessed segment, the second pre-adhesive is arranged corresponding to the second recessed segment, and an opening of the second recessed segment faces the second pre-adhesive.

In some embodiments, a distance between the second pre-adhesive and the first soldered segment located on the second recessed segment is 100 um to 2 mm; and/or
a length of the second pre-adhesive in the second direction is 300 um to 2 mm.

The present disclosure further provides a cell assembly, including a plurality of cell strings of any one of the above.

The present disclosure further provides a photovoltaic system, including the above cell assembly.

In the zero-busbar back-contact cell, the cell string, the cell assembly, and the photovoltaic system of the embodiments of the present disclosure, each of the first fingers has the first soldered segment at the crossing portion with each of the first series connection region, and at least one first soldered segment and the remaining first soldered segments are misaligned with each other in the first direction within the first series connection region. According to the arrangement order of the first soldered segments in the first direction, the first line segment formed by sequentially connecting the center points of all the first soldered segments is the non-straight segment, and the first line segment has at least one first recessed segment. Therefore, in the soldering process, the soldering layer may be arranged on the first soldered segment, when pre-fixing the ribbon using the first pre-adhesive, the first pre-adhesive may be arranged at a position where the opening of the first recessed segment faces, so that the distance between the first pre-adhesive and the first soldered segment in the first recessed segment corresponding to the first pre-adhesive is relatively far, even if the height of the first pre-adhesive is larger than that of the soldering layer, pseudo soldering in the subsequent soldering process may also be effectively avoided, and at the same time, the adhesion of the first pre-adhesive to the ribbon can also be ensured, thereby ensuring the stability of pre-fixing of the ribbon.

Additional aspects and advantages of the present disclosure will be partially set forth in the following description, and in part will be apparent from the following description, or may be learned by practice of the present disclosure.

### Brief Description of the Drawings

Fig. 1 is a schematic module diagram of a photovoltaic system according to an embodiment of the present disclosure.
Fig. 2 is a schematic module diagram of a cell assembly according to an embodiment of the present disclosure.
Fig. 3 is a schematic structural diagram of a cell string according to an embodiment of the present disclosure.
Fig. 4 is a schematic diagram of a planar structure of a back-contact solar cell piece according to an embodiment of the present disclosure.
Fig. 5 is a schematic diagram of arrangement of first soldered segments and first pre-adhesives of a zero-busbar solar cell piece within a first series connection region according to an embodiment of the present disclosure.
Fig. 6 is a schematic diagram of arrangement of first soldered segments of a zero-busbar solar cell piece within a first series connection region according to an embodiment of the present disclosure.
Fig. 7 is a schematic diagram of another arrangement of first soldered segments of a zero-busbar solar cell piece within a first series connection region according to an embodiment of the present disclosure.
Fig. 8 is a schematic diagram of still another arrangement of first soldered segments of a zero-busbar solar cell piece within a first series connection region according to an embodiment of the present disclosure.
Fig. 9 is a schematic diagram of arrangement of second soldered segments and second pre-adhesives of a zero-busbar solar cell piece within a second series connection region according to an embodiment of the present disclosure.

### Detailed Description of the Embodiments

In order to make the objectives, technical solutions and advantages of the present disclosure clearer, the present disclosure will be further described below in detail in conjunction with the drawings and embodiments. The embodiments described below with reference to the drawings are exemplary, and are only intended to be illustrative of the present disclosure and cannot be construed as limiting the present disclosure. In addition, it should be understood that specific embodiments described herein are merely intended to explain the present disclosure instead of limiting the present disclosure.

In the description of the present disclosure, it should be understood that the orientations or positional relationships indicated by the terms "length", "width", "top", "bottom", "transverse", "longitudinal", and the like are based on the orientations or positional relationships shown in the drawings, and are used only for ease and brevity of illustration and description of the present disclosure, rather than indicating or implying that the mentioned apparatus or element needs to have a particular orientation or needs to be constructed and operated in a particular orientation. Therefore, such terms should not be construed as a limitation on the present disclosure.

In addition, the terms "first" and "second" are used for descriptive purposes only, and cannot be understood as indicating or implying relative importance or implicitly specifying the number of technical features indicated. Therefore, the features defined with "first" and "second" may explicitly or implicitly include one or more features. In the description of the present disclosure, unless explicitly and specifically defined otherwise, "a plurality of" means two or more.

In the description of the present disclosure, it is to be noted that, unless otherwise clearly specified and limited, the terms "mounted", "connected" and "connect" should be interpreted broadly. For example, the term "connect" may be fixed connection, detachable connection or integral construction. As an alternative, the term "connect" may be mechanical connection, or electrical connection, or mutual communication. As an alternative, the term "connect" may be direct connection, or indirect connection through a medium, or communication in two elements or the interaction between two components. For those of ordinary skill in the art, specific meanings of the foregoing terms in the present disclosure may be understood based on specific situations.

In the present disclosure, unless otherwise explicitly specified and defined, a first feature being "over" or "below" a second feature may include that the first feature and the second feature are in direct contact, or the first feature and the second feature are not in direct contact but are in contact through another feature therebetween. Moreover, the first feature being "over", "above" and "on" the second feature includes that the first feature is directly above and obliquely above the second feature, or simply indicates that the horizontal height of the first feature is larger than that of the second feature. The first feature being "neath", "below" and "under" the second feature includes that the first feature is directly below and obliquely below the second feature, or simply indicates that the horizontal height of the first feature is less than that of the second feature.

The following disclosure provides various different embodiments or examples for implementing different structures of the present disclosure. In order to simplify the disclosure of the present disclosure, components and settings of specific examples are described below. Certainly, they are merely examples, and are not intended to limit the present disclosure. In addition, the present disclosure may repeat reference numerals and/or reference letters in different examples. The repetition is for the purpose of simplification and clarity, but does not indicate a relationship between the various embodiments and/or settings discussed. In addition, the present disclosure provides examples of various specific processes and materials, but those of ordinary skill in the art may be aware of the application of other processes and/or usage scenarios of other materials.

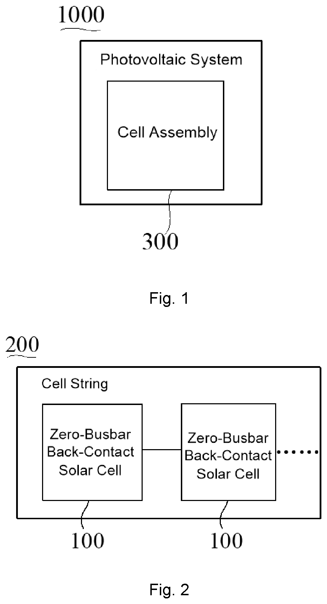

Referring to Fig. 1 to Fig. 2, a photovoltaic system 1000 in the embodiments of the present disclosure can include a cell assembly 300 in the embodiments of the present disclosure. The cell assembly 300 in the embodiments of the present disclosure can include a plurality of cell strings 200. The cell strings 200 in the cell assembly 300 can be connected in series, parallel, or a combination of series and parallel, so as to realize the convergence output of currents. For example, a connection between the cell strings 200 can be realized by busbars. The cell string 200 can include a plurality of zero-busbar back-contact cells 100 in the embodiments of the present disclosure.

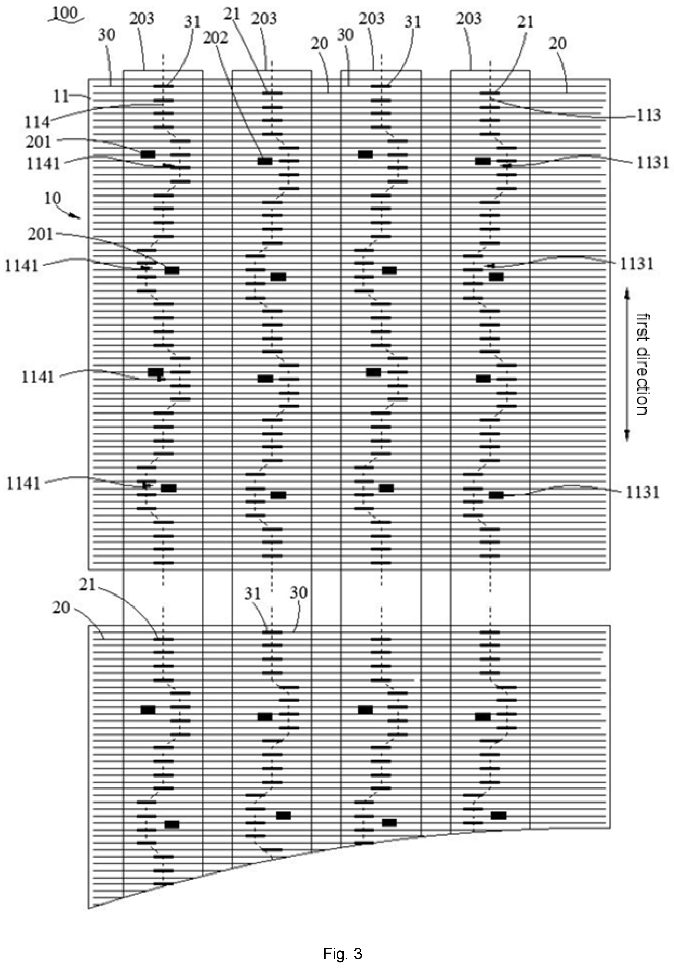

Referring to Fig. 3, the cell string can include a plurality of zero-busbar back-contact cells 100 in the embodiments of the present disclosure, a plurality of soldering layers (not shown), a plurality of first pre-adhesives 201, a plurality of second pre-adhesives 202, and a plurality of ribbons 203.

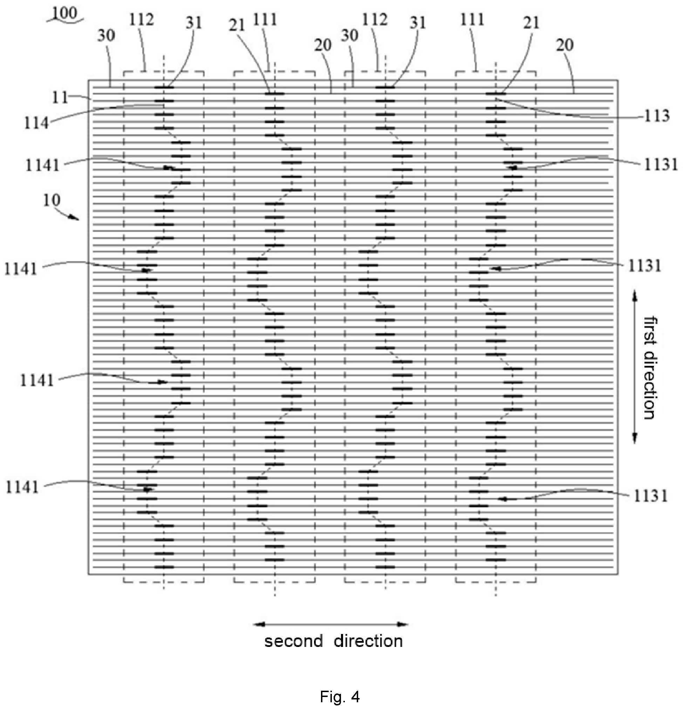

Referring to Fig. 3 and Fig. 4, the zero-busbar back-contact cell 100 in the embodiments of the present disclosure can include a silicon substrate 10, a plurality of first fingers 20, and a plurality of second fingers 30. The silicon substrate 10 includes a front surface and a back surface 11 opposite to each other, the plurality of first fingers 20 and the plurality of second fingers 30 are all arranged on the back surface 11 of the silicon substrate 10, the plurality of first fingers 20 and the plurality of second fingers 30 are sequentially and alternately arranged at intervals in a first direction, the first finger 20 and the second finger 30 both extend in a second direction, and the second direction crosses the first direction.

In some embodiments, as shown in Fig. 4, the first direction and the second direction may be a longitudinal direction and a transverse direction of the zero-busbar back-contact cell 100, respectively. In other embodiments, the first direction and the second direction can be other directions, for example, the two directions can be diagonal directions of the silicon substrate 10, respectively, which is not specifically limited herein.

As shown in Fig. 4, the back surface 11 includes a plurality of first series connection regions 111 and a plurality of second series connection regions 112 for arranging ribbons 203, the plurality of first series connection regions 111 and the plurality of second series connection regions 112 extending in the first direction and crossing all the first fingers 20 and all the second fingers 30, and the plurality of first series connection regions 111 and the plurality of second series connection regions 112 are sequentially and alternately arranged at intervals in the second direction.

Each of the first fingers 20 includes a first soldered segment 21 at a crossing portion with each of the first series connection regions 111, and all the first soldered segments 21 are located within the first series connection regions 111; each of the second fingers 30 includes a second soldered segment 31 at a crossing portion with each of the second series connection region 112, and all the second soldered segments 31 are located within the second series connection regions 112.

Referring to Fig. 4, at least one first soldered segment 21 and the remaining at least one first soldered segment 21 are misaligned with each other in the first direction within the first series connection region 111, that is, at least one first soldered segment 21 and the remaining at least one first soldered segment 21 are not completely aligned in the first direction (that is, they are not completely located on a same straight line parallel to the first direction).

As shown in Fig. 4, in the embodiments of the present disclosure, according to an arrangement order of the first soldered segments 21 within the first series connection region 111 in the first direction (for example, from top to bottom or from bottom to top), a first line segment 113 formed by sequentially connecting center points of all the first soldered segments 21 is a non-straight segment, and the first line segment 113 includes at least one first recessed segment 1131. The non-straight segment refers to the first line segment including at least one portion that is not on the same straight line as other portions, and the same description appearing below can be understood with reference herein.

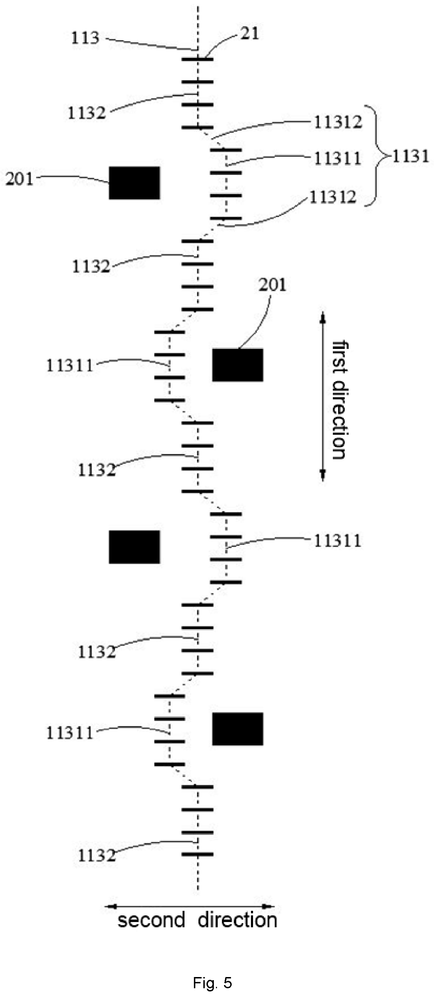

As shown in Fig. 3, in the cell string, the soldering layer is arranged on the first soldered segment 21 and the second soldered segment 31, and the soldering layer can be a material layer capable of achieving soldering, such as a solder paste soldering layer. The first pre-adhesive 201 is arranged within the first series connection region 111 and arranged corresponding to the first recessed segment 1131, and an opening of the first recessed segment 1131 faces the first pre-adhesive 201 (as shown in Fig. 3 and Fig. 5). The first pre-adhesive 201 can be completely provided outside the first recessed segment 1131 or partially provided inside the first recessed segment 1131.

Referring to Fig. 3 and Fig. 4, the second pre-adhesive 202 is arranged within the second series connection region 112, the ribbons 203 cover the first series connection regions 111 and the second series connection regions 112, and the ribbon 203 on the first series connection region 111 is bonded to the first pre-adhesive 201 and in contact with the soldering layer on the first soldered segment 21, and the ribbon 203 on the second series connection region 112 is bonded to the second pre-adhesive 202 and in contact with the soldering layer on the second soldered segment 31.

In the cell string 200, in two adjacent zero-busbar back-contact cells 100, the ribbon 203 on the previous first series connection region 111 is provided on the following second series connection region 112, and the ribbon 203 on the previous second series connection region 112 is provided on the following first series connection region 111, that is, the soldering layer (first soldered segment 21) within the first series connection region 111 of the previous zero-busbar back-contact cell 100 and the soldering layer (second soldered segment 31) within the second series connection region 112 of the following zero-busbar back-contact cell 100 are welded to the same ribbon.

It can be understood that, in the process of forming the cell assembly 300, the cell string 200 can be soldered first, and then the cell string 200 can be laminated to form an assembly, or the zero-busbar back-contact cells 100 can be first placed on a front plate and an adhesive film according to the assembly layout, and then the ribbons 203 can be placed for bonding and pre-fixing, and finally the lamination and soldering can be performed to directly form the cell assembly 300. In the lamination process, each of the zero-busbar back-contact cells 100 forms the cell string 200.

It is to be noted that the first series connection region 111 and the second series connection region 112 of the present disclosure refer to a region covered by the ribbon 203 on the back surface 11 and a region covered by the ribbon 203 on the back surface 11, which are not strictly divided by physical lines on the back surface 11, but are virtual defined regions.

In addition, it is also to be noted that the first line segment 113 in the present disclosure is not a physical line segment physically existing on the cell piece, but a virtual line. The first line segment 113 can be a smooth curve, a combination of at least one curve and at least one straight line, or a combination of at least one curve and at least one broken line, which is not specifically limited herein. For example, if the center points of the first soldered segments 21 in the region corresponding to the first recessed segment 1131 is a curved contour, then the first recessed segment 1131 can be a broken line segment formed by sequentially connecting the straight lines, or a smooth curved line segment, and Fig. 4 shows a broken line segment.

Furthermore, in the present disclosure, the center point of the first soldered segment 21 refers to a point where the first soldered segment 21 is divided into two symmetrical halves in the second direction, namely, a midpoint of the first soldered segment 21 in the second direction. It is not difficult to understand that, in the present disclosure, all the first soldered segments 21 have substantially the same length.

In addition, it is to be noted that, in some embodiments, within the first series connection region 111, insulating layers are arranged at the crossing portion of the first series connection region 111 and the second finger 30, that is, the insulating layer can be arranged at the crossing portion of each of the second fingers 30 and the ribbon 203, so as to prevent the ribbon 203 from contacting the fingers of different polarities.

In the zero-busbar back-contact cell 100, the cell string 200, the cell assembly 300, and the photovoltaic system 1000 of the embodiments of the present disclosure, each of the first fingers 20 includes the first soldered segment 21 at the crossing portion with each of the first series connection region 111, and all the first soldered segments 21 are located within the first series connection regions 111, and at least one first soldered segment 21 and the remaining first soldered segments 21 are misaligned with each other in the first direction within the first series connection region 111. According to the arrangement order of the first soldered segments 21 in the first direction, the first line segment 113 formed by sequentially connecting the center points of all the first soldered segments 21 is a non-straight segment, and the first line segment 113 includes at least one first recessed segment 1131. Therefore, as shown in the Fig. 3 and Fig. 5, in the soldering process, the soldering layers can be arranged on the first soldered segment 21, when pre-fixing the ribbon 203 using the first pre-adhesive 201, the first pre-adhesive 201 can be arranged at the portion where the opening of the first recessed segment 1131 faces, so that the distance between the first pre-adhesive 201 and the first soldered segment 21 in the first recessed segment 1131 corresponding to the first pre-adhesive 201 is relatively far, even if the height of the first pre-adhesive 201 is larger than that of the soldering layer, pseudo soldering in the subsequent soldering process can also be effectively avoided, and at the same time, the adhesion of the first pre-adhesive 201 to the ribbon 203 can also be ensured, thereby ensuring the stability of pre-fixing of the ribbon.

It is not difficult to understand that in the traditional technology, dispensing adhesive points are usually arranged on the grid line segments of the fingers for soldering, and a solder paste pad is arranged on the soldered segment, and the adhesive point needs to be provided near the center point of the ribbon as much as possible. Due to the short distance, the height of the adhesive point is larger than the height at the soldering point. In order to ensure the adhesion, the ribbon cannot be in contact with the corresponding soldering point near the adhesive point, easily resulting in pseudo soldering.

However, in the present disclosure, by arranging a portion of the first soldered segment 21 corresponding to the first pre-adhesive 201 into a recessed contour arrangement, the first pre-adhesive 201 is arranged corresponding to the opening of the recessed contour, so that the distance between the first pre-adhesive 201 and the corresponding first soldered segment 21 can be increased, which can effectively avoid the phenomenon of pseudo soldering in the soldering process.

In some embodiments, the first soldered segment 21 and the second soldered segment 31 are thick finger segments, that is, the first soldered segment 21 is thicker than other portions of the first finger 20, and the second soldered segment 31 is thicker than other portions of the second finger 30. In some embodiments, the length (the length in the second direction) of the first soldered segment 21 and the second soldered segment 31 can be 250 um to 350 um, and the width ( the length in the second direction) can be 25 um to 50 um, so that the contact area that between the first soldered segment 21 and the ribbon 203 and that between the second soldered segment 31 and the ribbon 203 can be ensured, thereby improving the stability of soldering.

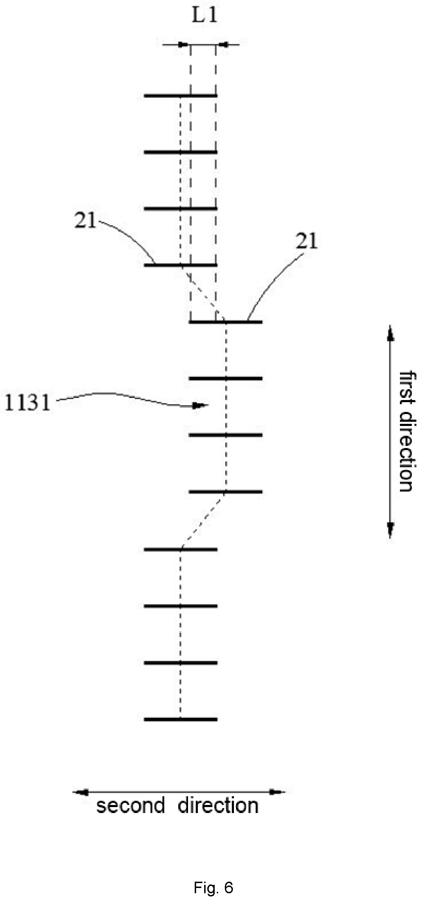

Referring to Fig. 6, in some embodiments, the two first soldered segments 21, which are misaligned with each other in the first direction, have an overlapping portion in the first direction. In such an embodiment, a length L1 of the overlapping portion in the second direction can be 50 um to 200 um, for example, 50 um, 60 um, 70 um, 80 um, 85 um, 90 um, 95 um, 100 um, 105 um, 115 um, 120 um, 130 um, 140 um, 150 um, 160 um, 170 um, 180 um, 190 um, 200 um. Therefore, the first soldered segments 21 can be arranged closely.

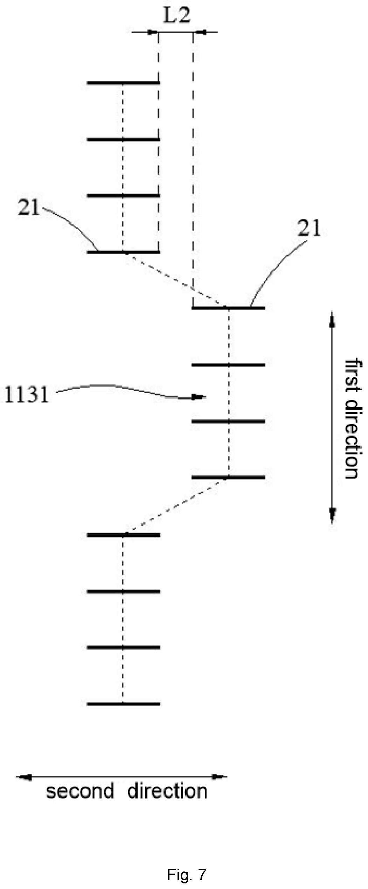

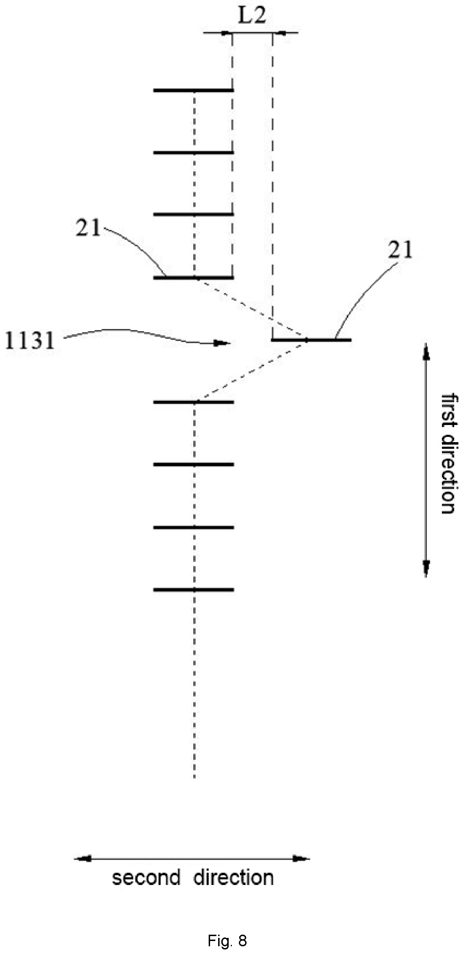

As shown in Fig. 7 and Fig. 8, in some embodiments, the two first soldered segments 21, which are misaligned with each other in the first direction, can also be spaced apart from each other in the second direction, which is not specifically limited herein. In such an embodiment, a distance L2 between the above two first soldered segments 21, which are misaligned with each other in the above first direction, in the above second direction can be 100 um to 1 mm, for example, 100 um, 200 um, 300 um, 350 um, 400 um, 500 um, 600um, 700 um, 800 um, 900 um, 1 mm.

Referring to Fig. 3 and Fig. 5, in some embodiments, a number of the first soldered segments 21 corresponding to each of the first recessed segment 1131. In this way, the first pre-adhesive 201 can be far away from a plurality of nearby first soldered segments 21, thereby better avoiding pseudo soldering.

As shown in Fig. 6 to Fig. 8, in some embodiments, the first recessed segment 1131 can also correspond to only a single first soldered segment 21, which is not specifically limited herein.

Referring to Fig. 4 and Fig. 5, in some embodiments, each of the above first recessed segments 1131 corresponds to at least one first pre-adhesive 201, that is, the first recessed segment 1131 is provided with at least one first pre-adhesive 201 within a range corresponding to the second direction, and the first pre-adhesive 201 can be arranged in the first recessed segment 1131 close to the center line of the ribbon 203, or can be provided outside the first recessed segment 1131.

Referring to Fig. 5, in some embodiments, the first line segment 113 further includes at least one first straight segment 1132, the first straight segment 1132 is arranged parallel to the first direction, and the first recessed segment 1131 is offset in the second direction relative to the first straight segment 1132.

Therefore, by arranging the first straight segment 1132, and the first soldered segment 21 on the first straight segment 1132 is located on the same straight line parallel to the first direction, so that the soldering efficiency can be improved in the soldering process (for example, laser soldering), and at the same time, the reliability and stability of soldering can be improved by providing a plurality of soldering points on the same straight line of the ribbon 203.

Referring to Fig. 5, in some embodiments, the first recessed segment 1131 can include at least one first sub-straight segment 11311 parallel to the first straight segment 1132 and at least one first inclined segment 11312 connecting the first sub-straight segment 11311 and the first straight segment 1132.

Therefore, the at least one first sub-straight segment 11311 and the at least one first inclined segment 11312 constitute the first recessed segment 1131, and the first soldered segments 21 correspondingly on the first sub-straight segments 11311 is located on the same straight line parallel to the first direction, which can increase the number of soldering points on a same straight line of the ribbon 203 to improve the reliability and stability of soldering.

Referring to Fig. 5, in some embodiments, there are a number of the first straight segments 1132 and the first recessed segments 1131, and the plurality of first straight segments 1132 and the plurality of first recessed segments 1131 are sequentially and alternately arranged at intervals.

Therefore, by arranging the plurality of first straight segments 1132 and the plurality of the first recessed segments 1131, at least one first pre-adhesive 201 can be arranged at the position corresponding to each of the first recessed segments 1131, so that the plurality of first pre-adhesives 201 are arranged in a case of effectively avoiding pseudo soldering, thereby improving the stability and adhesion when pre-fixing the ribbon 203.

Referring to Fig. 5, in such an embodiment, in the two first recessed segments 1131 at both ends of the first straight segment 1132, one of the first recessed segments 1131 is recessed toward one side of the first straight segment 1132 and the other of the first recessed segments 1131 is recessed toward the other side of the first straight segment 1132.

Therefore, the recessed directions of the two adjacent first recessed segments 1131 are opposite (that is, the openings of the two adjacent first recessed segments 1131 are oriented in opposite directions). In this way, the positions of the first pre-adhesives 201 corresponding to the two adjacent first recessed segments 1131 are also opposite (respectively located on both sides of the first straight segment 1132), which can avoid the first pre-adhesives 201 being concentrated on one side of the first straight segment 1132.

It can be understood that, in some embodiments, the first recessed segment 1131 can also be an arc-shaped segment, that is, the first line segment 113 can be composed of at least one first straight segment 1132 and at least one arc-shaped segment.

In some embodiments, the first line segment 113 can also be in other forms, for example, in some embodiments, the first line segment 113 can be a wavy line, that is, in an up-down direction of the first direction, the arrangement contour of the first soldered segments 21 is wavy, and the entire first line segment 113 is an arc curve, which is not specifically limited herein.

Referring to Fig. 3, Fig. 4, and Fig. 9, in some embodiments, each of the second fingers 30 includes the second soldered segment 31 at the crossing portion with each of the second series connection regions 112, and all the second soldered segments 31 are located within the second series connection regions 112, and at least one second soldered segment 31 and the remaining at least one second soldered segment 31 are misaligned with each other in the first direction within the second series connection region 112.

According to an arrangement order of the second soldered segments 31 in the first direction, a second line segment 114 formed by sequentially connecting center points of all the second soldered segments 31 is a non-straight segment, and the second line segment 114 includes at least one second recessed segment 1141.

Therefore, in the soldering process, the soldering layer can be arranged on the second soldered segment 31, when pre-fixing the ribbon 203 using the second pre-adhesive 202, the second pre-adhesive 202 can be arranged at a position where the opening of the second recessed segment 1141 faces, so that the distance between the second pre-adhesive 202 and the second soldered segment 31 in the second recessed segment 1141 corresponding to the second pre-adhesive 202 can be relatively far, which can effectively avoid pseudo soldering in the subsequent soldering process while ensuring the adhesion of the second pre-adhesive 202 to the ribbon 203.

In some embodiments, the two second soldered segments 31, which are misaligned with each other in the first direction, include an overlapping portion in the first direction (similar to the structure of the first soldered segment 21 shown in Fig. 6). In such an embodiment, a length of the overlapping portion in the second direction can be 50 um to 200 um, for example, 50 um, 60 um, 70 um, 80 um, 85 um, 90 um, 95 um, 100 um, 105 um, 115 um, 120 um, 130 um, 140 um, 150 um, 160 um, 170 um, 180 um, 190 um, 200 um. Therefore, the ribbons 203 can be arranged more closely.

In some embodiments, the two second soldered segments 31, which are misaligned with each other in the first direction, can also be spaced apart from each other in the second direction (similar to the structure of the first soldered segment 21 shown in Fig. 7), which is not specifically limited herein. In such an embodiment, a distance between the above two second soldered segments 31, which are misaligned with each other in the above first direction, in the second direction can be 100 um to 1 mm, for example, 100 um, 200 um, 300 um, 350 um, 400 um, 500 um, 600um, 700 um, 800 um, 900 um, 1 mm.

Referring to Fig. 3, Fig. 4 and Fig. 9, in some embodiments, there are a number of the second soldered segments 31 corresponding to each of the second recessed segments 1141. In this way, the second pre-adhesive 202 can be far away from the plurality of nearby second soldered segments 31, thereby better avoiding pseudo soldering.

In some embodiments, the second recessed segment 1141 can also correspond to only a single second soldered segment 31 (similar to Fig. 8), which is not specifically limited herein.

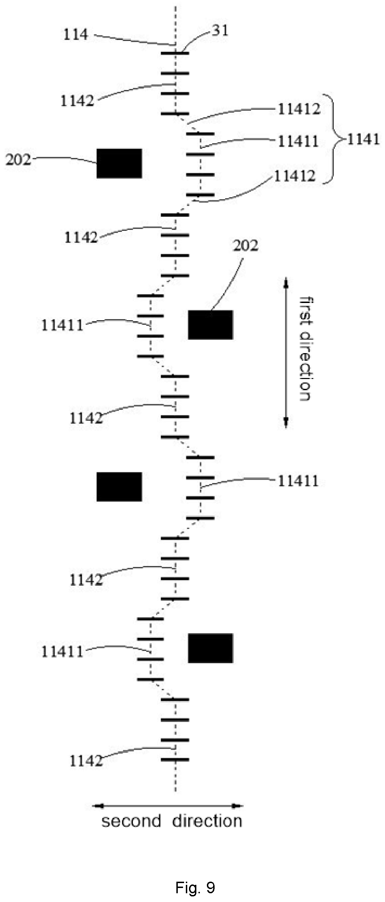

Referring Fig. 4 and Fig. 9, in some embodiments, each of the second recessed segments 1141 corresponds to at least one second pre-adhesive 202, that is, the second recessed segment 1141 is provided with at least one second pre-adhesive 202 within the range corresponding to the second direction, and the second pre-adhesive 202 can be arranged in the second recessed segment 1141 close to the center line of the ribbon 203, or can be provided outside the second recessed segment 1141.

Referring to Fig. 9, in some embodiments, the second line segment 114 further includes at least one second straight segment 1142, the second straight segment 1142 being arranged parallel to the first direction, and the second recessed segment 1141 is offset in the second direction relative to the second straight segment 1142.

Therefore, by arranging the at least one second straight segment 1142, the second soldered segment 31 on the second straight segment 1142 is located on a same straight line parallel to the first direction, so that the soldering efficiency can be improved in the soldering process (for example, laser soldering), and at the same time, the reliability and stability of soldering can be improved by having the plurality of soldering points on the same straight line of the ribbon 203.

Referring to Fig. 9, in some embodiments, the second recessed segment 1141 includes at least one second sub-straight segment 11411 parallel to the second straight segment 1142 and at least one second inclined segment 11412 connecting the second sub-straight segment 11411 and the second straight segment 1142.

Therefore, the at least one second sub-straight segment 11411 and the at least one second inclined segment 11412 constitute the second recessed segment 1141, and the second soldered segments 31 correspondingly on the second sub-straight segment 11411 can be located on the same grid line parallel to the first direction, which can increase the number of soldering points on the same straight line of the ribbon 203 to improve the reliability and stability of soldering.

Referring to Fig. 9, in some embodiments, there are a number of the second straight segments 1142 and a number of the second recessed segments 1141, and the plurality of second straight segments 1142 and the second recessed segments 1141 are sequentially and alternately arranged at intervals.

Therefore, by arranging the plurality of the second straight segments 1142 and the plurality of second recessed segments 1141, at least one second pre-adhesive 202 can be arranged at the portion corresponding to each of the second recessed segments 1141, so that the plurality of second pre-adhesives 202 are arranged in a case of effectively avoiding pseudo soldering, thereby improving the stability and adhesion of pre-fixing the ribbon 203.

Referring to Fig. 9, in such an embodiment, in the two second recessed segments 1141 at both ends of the second straight segment 1142, one of the second recessed segments 1141 is recessed toward one side of the second straight segment 1142 and the other of the second recessed segments 1141 is recessed toward the other side of the second straight segment 1142.

Therefore, the recessed directions of the two adjacent second recessed segments 1141 are opposite (that is, the openings of the two adjacent second recessed segments 1141 are oriented in opposite directions). In this way, the positions of the second pre-adhesives 202 corresponding to the two adjacent second recessed segments 1141 are also opposite (respectively located on both sides of the second straight segment 1142), which can avoid the second pre-adhesives 202 being concentrated on one side of the second straight segment 1142.

It can be understood that, in some embodiments, the second recessed segment 1141 can also be an arc-shaped segment, that is, the first line segment 114 can be composed of at least one second straight segment 1142 and at least one arc-shaped segment.

In addition, in some embodiments, the second line segment 114 can also be in other forms, for example, the second line segment 114 can also be a wavy line, that is, in the up-down direction of the first direction, the arrangement contour of the second soldered segments 31 is wavy, and the entire second line segment 114 is an arc curve, which is not specifically limited herein.

In the description of the specification, descriptions of the reference terms "one embodiments", "some embodiments", "example", "specific example", "some examples", or the like mean that specific features, structures, materials, or characteristics described in combination with the above embodiments or the examples are included in at least one embodiment or example of the present disclosure. In this specification, schematic representations of the above terms do not necessarily refer to the same embodiment or example. Furthermore, the specific features, structures, materials, or characteristics described may be combined in any suitable manner in any one or more embodiments or examples.

Although the embodiments of the present disclosure have been shown and described, those of ordinary skill in the art may understand that various changes, modifications, substitutions and variations may be made to these embodiments without departing from the principle and purpose of the present disclosure, and the scope of the present disclosure is defined by the claims and their equivalents.

## Claims

1. A zero-busbar back-contact cell, comprising a silicon substrate and a plurality of first fingers and a plurality of second fingers arranged on a back surface of the silicon substrate, wherein the plurality of first fingers and the plurality of second fingers are sequentially and alternately arranged at intervals in a first direction, each extending in a second direction, and the second direction crosses the first direction; the back surface comprises a plurality of first series connection regions and a plurality of second series connection regions for arranging ribbons, the plurality of first series connection regions and the plurality of second series connection regions extending in the first direction and crossing all the first fingers and all the second fingers, and the plurality of first series connection regions and the plurality of second series connection regions are sequentially and alternately arranged at intervals in the second direction;
each of the first fingers comprises a first soldered segment at a crossing portion with each of the first series connection regions, and all the first soldered segments are located within the first series connection regions; each of the second fingers comprises a second soldered segment at a crossing portion with each of the second series connection regions, and all the second soldered segments are located within the second series connection regions;
wherein at least one first soldered segment and the remaining at least one first soldered segment are misaligned with each other in the first direction within the first series connection region; and
according to an arrangement order of the first soldered segments in the first direction, a first line segment formed by sequentially connecting center points of all the first soldered segments is a non-straight segment, and the first line segment comprises at least one first recessed segment.

2. The zero-busbar back-contact cell according to claim 1, wherein every two first soldered segments, which are misaligned with each other in the first direction, comprise an overlapping portion in the first direction.

3. The zero-busbar back-contact cell according to claim 2, wherein a length of the overlapping portion in the second direction is 50 um to 200 um.

4. The zero-busbar back-contact cell according to claim 1, wherein every two first soldered segments, which are misaligned with each other in the first direction, are spaced apart from each other in the second direction.

5. The zero-busbar back-contact cell according to claim 4, wherein a distance between the two first soldered segments, which are misaligned with each other in the first direction, in the second direction is 100 um to 2.5 mm.

6. The zero-busbar back-contact cell according to claim 1, wherein a number of the first soldered segments corresponding to each of the first recessed segment.

7. The zero-busbar back-contact cell according to claim 1, wherein the first line segment further comprises at least one first straight segment, the first straight segment being arranged parallel to the first direction, and the first recessed segment is offset in the second direction relative to the first straight segment.

8. The zero-busbar back-contact cell according to claim 7, wherein the first recessed segment comprises at least one first sub-straight segment parallel to the first straight segment and at least one first inclined segment connecting the first sub-straight segment and the first straight segment.

9. The zero-busbar back-contact cell according to claim 7 or 8, comprising a number of the first straight segments and the first recessed segments, and a plurality of first straight segments and a plurality of first recessed segments are sequentially and alternately arranged.

10. The zero-busbar back-contact cell according to claim 9, wherein, in every two first recessed segments at both ends of the first straight segment, one of the first recessed segments is recessed toward one side of the first straight segment and the other of the first recessed segments is recessed toward the other side of the first straight segment.

11. The zero-busbar back-contact cell according to claim 1, wherein the first line segment is a wavy line.

12. The zero-busbar back-contact cell according to claim 1, wherein each of the second fingers comprises a second soldered segment at a crossing portion with each of the second series connection regions, and all the second soldered segments are located within the second series connection regions, and at least one second soldered segment and the remaining at least one second soldered segment are misaligned with each other in the first direction within the second series connection regions;
wherein, according to an arrangement order of the second soldered segments in the first direction, a second line segment formed by sequentially connecting center points of all the second soldered segments is a non-straight segment, and the second line segment comprises at least one second recessed segment.

13. The zero-busbar back-contact cell according to claim 12, wherein every two second soldered segments, which are misaligned with each other in the first direction, comprise an overlapping portion in the first direction.

14. The zero-busbar back-contact cell according to claim 13, wherein a length of the overlapping portion in the second direction is 50 um to 200 um.

15. The zero-busbar back-contact cell according to claim 12, wherein every two second soldered segments, which are misaligned with each other in the first direction, are spaced apart from each other in the second direction.

16. The zero-busbar back-contact cell according to claim 15, wherein a distance between the two second soldered segments, which are misaligned with each other in the first direction, in the second direction is 100 um to 2.5 mm.

17. The zero-busbar back-contact cell according to claim 12, wherein the second line segment further comprises at least one second straight segment, the second straight segment being arranged parallel to the second direction, and the second recessed segment is offset in the second direction relative to the second straight segment.

18. The zero-busbar back-contact cell according to claim 17, wherein the second recessed segment comprises at least one second sub-straight segment parallel to the second straight segment and at least one second inclined segment connecting the second sub-straight segment and the second straight segment.

19. The zero-busbar back-contact cell according to claim 17 or 18, wherein the number of the second straight segments and the second recessed segments is plural, and the plurality of second straight segments and the plurality of second recessed segments are sequentially and alternately arranged.

20. The zero-busbar back-contact cell according to claim 19, wherein, in every two second recessed segments at both ends of the second straight segment, one of the second recessed segments is recessed toward one side of the second straight segment and the other of the second recessed segments is recessed toward the other side of the second straight segment.

21. The zero-busbar back-contact cell according to claim 12, wherein the second line segment is a wavy line.

22. A cell string, comprising:
a plurality of zero-busbar back-contact cells according to any one of claims 1 to 21;
soldering layers arranged on the first soldered segments and the second soldered segments;
first pre-adhesives arranged within the first series connection region and arranged corresponding to the first recessed segment, and an opening of the first recessed segment facing the first pre-adhesive;
second pre-adhesives arranged within the second series connection region; and
ribbons covering the first series connection regions and the second series connection regions, the ribbon on the first series connection region being bonded to the first pre-adhesive and in contact with the soldering layer on the first soldered segment, and the ribbon on the second series connection region being bonded to the second pre-adhesive and in contact with the soldering layer on the second soldered segment.

23. The cell string according to claim 22, wherein a distance between the first pre-adhesive and the first soldered segment located on the first recessed segment is 100 um to 2 mm; and/or
a length of the first pre-adhesive in the second direction is 300 um to 2 mm.

24. The cell string according to claim 22, wherein a number of the first pre-adhesives corresponding to the single first recessed segment.

25. The cell string according to claim 22, wherein at least one second soldered segment and the remaining at least one second soldered segment are misaligned with each other in the first direction within the second series connection region;
wherein, according to an arrangement order of the second soldered segments in the first direction, a second line segment formed by sequentially connecting center points of all the second soldered segments is a non-straight segment, the second line segment has at least one second recessed segment, the second pre-adhesive is arranged corresponding to the second recessed segment, and an opening of the second recessed segment faces the second pre-adhesive.

26. The cell string according to claim 25, wherein a distance between the second pre-adhesive and the first soldered segment located on the second recessed segment is 100 um to 2 mm; and/or
a length of the second pre-adhesive in the second direction is 300 um to 2 mm.

27. A cell assembly, comprising the cell string according to any one of claims 22 to 26.

28. A photovoltaic system, comprising the cell assembly according to claim 27.
